# EUROPÄISCHE PATENTSCHRIFT

(11) **EP 1 163 675 B1**
(45) Veröffentlichungstag und Bekanntmachung des Hinweises auf die Patenterteilung: **05.11.2003**
(21) Anmeldenummer: 00918694.1
(22) Anmeldetag: 10.03.2000
(51) Int. Cl.: G11C 7/14, G11C 11/22

(54) **INTEGRIERTER SPEICHER MIT SPEICHERZELLEN UND REFERENZZELLEN SOWIE BETRIEBSVERFAHREN FÜR EINEN SOLCHEN SPEICHER**
INTEGRATED MEMORY WITH MEMORY CELLS AND REFERENCE CELLS AND OPERATING METHOD FOR A MEMORY OF THIS TYPE
MEMOIRE INTEGREE A CELLULES DE MEMOIRE ET A CELLULES DE REFERENCE ET PROCEDE DE FONCTIONNEMENT DE LADITE MEMOIRE

(30) Priorität: 23.03.1999 DE 19913108
(43) Veröffentlichungstag der Anmeldung: 19.12.2001
(73) Patentinhaber: Infineon Technologies AG, 81669 München (DE)
(72) Erfinder: BÖHM, Thomas, D-85604 Zorneding (DE); BRAUN, Georg, D-80339 München (DE); HÖNIGSCHMID, Heinz, D-82343 Pöcking (DE); MANYOKI, Zoltan, Kanata, Ontario K2L 3W9 (CA); RÖHR, Thomas, D-85609 Aschheim (DE)
(74) Vertreter: Beck, Josef
(86) Internationale Anmeldenummer: DE0000759
(87) Internationale Veröffentlichungsnummer: WO00057422

(56) Entgegenhaltungen:
- US-A- 5 751 626

## Beschreibung

Die Erfindung betrifft einen integrierten Speicher mit Speicherzellen und Referenzzellen sowie ein Betriebsverfahren für einen solchen Speicher.

In der US 5,844,832 A und in der US 5,572,459 A sind ferroelektrische Speicher (FRAM beziehungsweise FeRAM) beschrieben, die Speicherzellen vom l-Transistor/l-Kondensator-Typ aufweisen. Der Speicherkondensator weist ein ferroelektrisches Dielektrikum auf, dessen Polarisation zum Speichern unterschiedlicher logischer Zustände auf unterschiedliche Werte eingestellt wird. Durch Einstellen der Polarisation des Dielektrikums wird die Kapazität des Speicherkondensators beeinflußt. Da die genannten Speicherzellen bei einem Lesezugriff aufgrund ihrer beschränkten Kapazität nur geringe Potentialveränderungen auf den mit ihnen verbundenen Bitleitungen bewirken können, weisen diese Speicher differentielle Leseverstärker auf, wie sie beispielsweise auch bei DRAMs (Dynamic Random Access Memories) zum Einsatz kommen. Jeder Leseverstärker ist mit einem Paar von Bitleitungen verbunden. Bei einem Lesezugriff auf eine der Speicherzellen wird diese über eine der Bitleitungen elektrisch mit dem zugehörigen Leseverstärker verbunden, während die andere Bitleitung des mit diesem Leseverstärker verbundenen Bitleitungspaares eine Referenzzelle mit dem zweiten Eingang des Leseverstärkers elektrisch verbindet.

Die Referenzzellen sind im wesentlichen wie die normalen Speicherzellen der FRAMs aufgebaut und dienen der Erzeugung eines Referenzpotentials auf der entsprechenden zweiten Bitleitung. Der Leseverstärker verstärkt dann die sich einstellende Potentialdifferenz zwischen den beiden Bitleitungen. Um das gewünschte Referenzpotential auf der zweiten Bitleitung zu erzeugen, ist es notwendig, in der Referenzzelle zuvor eine entsprechende Referenzinformation zu speichern. Hierzu sind sowohl in der US 5,572,459 A als auch in der US 5,844,832 A die Referenzzellen im Vergleich zu den normalen Speicherzellen modifiziert, indem sie über zusätzliche Transistoren mit Potentialleitungen verbunden sind, die zur Zuführung der gewünschten Referenzinformation dienen. Diese zusätzlichen Transistoren sind mit einem Schaltungsknoten innerhalb der Speicherzelle verbunden, der sich zwischen dem jeweiligen Auswahltransistor und dem Speicherkondensator der Referenzzelle befindet.

Die oben erwähnten, durch einen zusätzlichen Transistor modifizierten Speicherzellen weisen den Nachteil auf, daß sie aufgrund des zusätzlich vorhandenen Transistors nicht völlig identisch wie die normalen Speicherzellen aufgebaut sind. Dies hat zur Folge, daß die Referenzzellen nicht im gleichen Raster wie die normalen Speicherzellen hergestellt werden können. Hierdurch ergibt sich ein aufwendigerer Herstellungsprozeß des Speichers.

Aus US 5,751,626 ist ein ferroelektrischer Speicher mit ferroelektrischen Referenzzellen bekannt, wobei die Speicherzellen selektiv ausgewählt oder ausgelesen werden können. Zur Auswertung der Speicherzelle wird eine Referenzzelle verwendet, die eine Referenzspannung erzeugt. Die Referenzspannung wird mit der Spannung verglichen, die von der Speicherzelle beim Auslesen erzeugt wird. Die Speicherzellen sind über Bitleitungspaare mit einer Verstärkerschaltung verbunden. Jede Bitleitung ist über einen Transistor mit einer Speicherzelle verbindbar. Für ein Bitleitungspaar ist eine Referenzzelle vorgesehen.

In einer weiteren Ausführungsform ist jeder Bitleitung eines Bitleitungspaares eine Referenzzelle zugeordnet, die jedoch unterschiedliche Spannungspegel aufweisen. Werden die zwei Bitleitungen und die zwei Referenzspeicherzellen miteinander verbunden, so stellt sich ein Spannungspegel ein, der die Hälfte des Spannungspegels einer logischen 1 darstellt.

Der Erfindung liegt die Aufgabe zugrunde, einen integrierten Speicher der beschriebenen Art anzugeben, dessen Speicherzellen und Referenzzellen in einem regelmäßigen Raster angeordnet werden können.

Diese Aufgaben werden mit einem integrierten Speicher gemäß Patentanspruch 1 und mit einem Betriebsverfahren gemäß Patentanspruch 8 gelöst. Vorteilhafte Aus- und Weiterbildungen der Erfindung sind Gegenstand der abhängigen Patentansprüche.

Der integrierte Speicher weist identisch aufgebaute Speicherzellen und Referenzzellen auf. Die zweiten Schaltelemente dienen zur Zuführung der Referenzinformation in die Referenzzellen. Da die zweiten Schaltelemente nicht mit einem Schaltungsknoten innerhalb der Referenzzelle, sondern mit einem Schaltungsknoten auf der zugehörigen Bitleitung verbunden sind, müssen die Referenzzellen gegenüber den Speicherzellen nicht modifiziert werden. Dies ermöglicht zum einen die Herstellung des die Speicherzellen und Referenzzellen aufweisenden Speicherzellenfeldes in einem regelmäßigen Raster, dessen Ausdehnung durch die minimalen Abmessungen der Speicherzellen vorgegeben ist. Zum anderen ergibt sich der Vorteil, daß das Einschreiben und Auslesen der Referenzinformation in die Referenzzellen auf gleiche Weise erfolgt, wie das Einschreiben beziehungsweise Auslesen von Daten in die Speicherzellen. Da das genaue Verhalten der Speicherzellen bei einem Zugriff auch von Schwankungen des Herstellungsprozesses abhängt, wird das Zugriffsverhalten der Referenzzellen, die identisch wie die Speicherzellen aufgebaut sind, aufgrund derartiger Einflüsse in gleicher Weise beeinflußt wie dasjenige der Speicherzellen. Somit ist gewährleistet, daß die von den Referenzzellen zur Verfügung gestellte Referenzinformation auch für unterschiedliche Herstellungsbedingungen des Speichers an das veränderte Zugriffsverhalten der normalen Speicherzellen angepaßt ist.

Nach einer Weiterbildung der Erfindung sind die Referenzzellen und die ersten Schaltelemente an einem dem Leseverstärker gegenüberliegenden Ende der jeweiligen Bitleitung angeordnet. Hierdurch ergibt sich eine schaltungstechnisch vorteilhafte Anordnung, bei der relativ wenige Steuersignale zur Ansteuerung der ersten Schaltelemente benötigt werden. Um das Raster des Zellenfeldes beizubehalten, können die ersten Schaltelemente ebenfalls in diesem Raster angeordnet werden.

Nach einer anderen Weiterbildung der Erfindung sind die ersten Schaltelemente am dem Leseverstärker zugewandten Ende der jeweiligen Bitleitung angeordnet. Dies hat den Vorteil, daß bei den Leseverstärkern oftmals ausreichend Platz zur Verfügung steht und sich die Schaltelemente daher problemloser anordnen lassen, auch wenn aufgrund von sehr kleinen Speicherzellen das Raster des Speicherzellenfeldes sehr klein wird.

Die Erfindung wird im folgenden anhand der Figuren näher erläutert, die Ausführungsbeispiele darstellen. Es zeigen:
- Figur 1: ein erstes Ausführungsbeispiel eines integrierten Speichers, das nicht Gegenstand des Patentes ist.
- Figur 2: eine Variante des integrierten Speichers aus Figur 1,
- Figur 3: ein weiteres Ausführungsbeispiel des integrierten Speichers, das nicht Gegenstand des Patentes ist.
- Figur 4: eine Variante des Ausführungsbeispiels aus Figur 3 und
- Figur 5: den Aufbau einer Speicherzelle und einer Referenzzelle der unterschiedlichen Ausführungsbeispiele.

Obwohl im folgenden die Erfindung anhand von Ausführungsbeispielen erläutert wird, die einen ferroelektrischen Speicher vom Typ FRAM betreffen, ist die Erfindung auf solche Speicher nicht beschränkt. Sie eignet sich zur Anwendung bei allen integrierten Speichern, die differentielle Leseverstärker sowie damit verbundene Bitleitungspaare aufweisen, an die neben den normalen Speicherzellen auch Referenzzellen angeschlossen sind. Beispielsweise eignet sich die Erfindung auch zur Anwendung bei DRAMs.

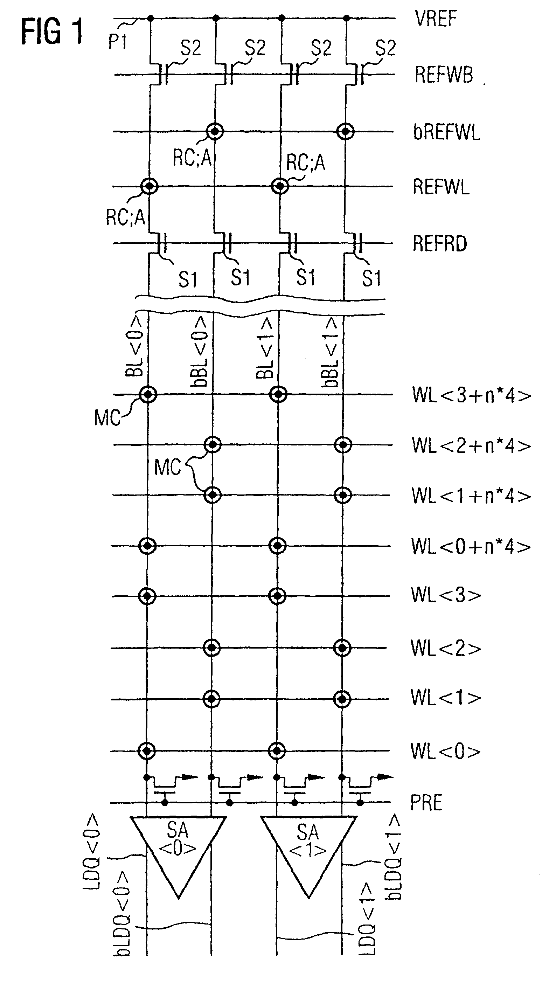

Figur 1 zeigt einen Ausschnitt eines Speicherzellenfeldes eines integrierten Speichers vom Typ FRAM. Gezeigt sind zwei Bitleitungspaare BLi, bBli, die mit je einem differentiellen Leseverstärker SAi verbunden sind. Die Leseverstärker SAi verstärken bei einem Lesezugriff auf dem jeweiligen Bitleitungspaar vorhandene Spannungen und geben diese verstärkt an Datenleitungspaare LDQi, bLDQi weiter. Bei einem Schreibzugriff übertragen sie eine Spannung vom Datenleitungspaar zum jeweiligen Bitleitungspaar. Obwohl in Figur 1 nur zwei Bitleitungspaare BLi, bBLi dargestellt sind, weist der Speicher eine Vielzahl von Bitleitungspaaren mit entsprechenden Leseverstärkern SAi auf. Obwohl bei den hier geschilderten Ausführungsbeispielen das "Folded Bitline-Konzept" dargestellt wird, bei dem die beiden Bitleitungen jedes Bitleitungspaares parallel zueinander verlaufen, ist die Erfindung ebensogut auf nach dem "Open Bitline-Konzept" aufgebaute Speicher anwendbar, bei denen die beiden Bitleitungen eines Bitleitungspaares auf verschiedenen Seiten des zugehörigen Leseverstärkers angeordnet sind.

In Kreuzungspunkten der Bitleitungen mit Wortleitungen WLi sind normale Speicherzellen MC angeordnet. Weiterhin ist eine Vorladeleitung PRE vorhanden, die mit Gates von Transistoren verbunden ist, über die jede der Bitleitungen BLi, bBli mit einem Vorladepotential verbunden ist.Der Speicher weist weiterhin Referenzzellen RC auf, die in Kreuzungspunkten der Bitleitungen BLi, bBLi mit Referenzwortleitungen REFWL, bREFWL angeordnet sind. Die Referenzzellen RC sind mit den Bitleitungen in Schaltungsknoten A verbunden.

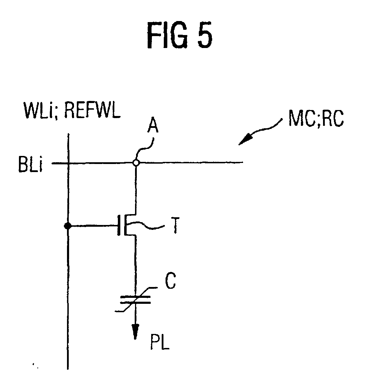

Die Speicherzellen MC und die Referenzzellen RC sind identisch aufgebaut. Figur 5 zeigt ihren Aufbau. Sie weisen jeweils einen Auswahltransistor T und einen Speicherkondensator C mit ferroelektrischem Dielektrikum auf. Die eine Elektrode des Speicherkondensators C ist mit einem Plattenpotential PL und die andere Elektrode ist über den Auswahltransistor T mit der entsprechenden Bitleitung BLi verbunden. Das Gate des Auswahltransistors T ist mit einer der Wortleitungen WLi beziehungsweise einer der Referenzwortleitungen REFWL verbunden. Für die Referenzzellen RC ist in Figur 5 auch der Schaltungsknoten A eingezeichnet, an dem die Referenzzelle mit der zugehörigen Bitleitung BLi verbunden ist.

Figur 1 ist zu entnehmen, daß die Bitleitungen BLi, bBLi dieses Ausführungsbeispiels in zwei Bereiche unterteilt sind, nämlich einen ersten Bereich, in dem sie mit den Speicherzellen MC verbunden sind, und einen zweiten Bereich, in dem sie mit den Referenzzellen RC verbunden sind. Die beiden Bereiche der Bitleitungen sind über erste Schaltelemente S1 miteinander verbunden. Weiterhin ist eine erste Potentialleitung P1 mit dem Ende der Bitleitungen BLi, bBLi über zweite Schaltelemente S2 verbunden. Die ersten S1 und zweiten S2 Schaltelemente sind bei den hier betrachteten Ausführungsbeispielen n-Kanal-Transistoren. Die Gates der vier ersten Schaltelemente S1 sind mit einer Referenzleseleitung REFRD und die Gates der zweiten Schaltelemente S2 mit einer Referenzschreibleitung REFWB verbunden.

Im folgenden wird ein Lesezugriff auf den in Figur 1 dargestellten Speicher beschrieben. Zunächst wird über die vorladeleitung dafür gesorgt, daß alle Bitleitungen BLi, bBLi auf das Vorladepotential vorgeladen werden. Anschließend werden die mit dem Vorladepotential verbundenen Transistoren wieder gesperrt. Dann wird eine der Wortleitungen WLi auf ein hohes Potential gebracht, während die übrigen Wortleitungen auf niedrigem Potential bleiben. Hierdurch werden die beiden mit der aktivierten Wortleitung WLi verbundenen Speicherzellen MC ausgewählt, indem ihre Speicherkondensatoren C über ihren Auswahltransistor T elektrisch leitend mit der zugehörigen Bitleitung verbunden werden. Gleichzeitig zur Aktivierung einer der Wortleitungen WLi wird diejenige der Referenzwortleitungen REFWL, bREFWL auf einen hohen Pegel gebracht, die den Referenzzellen RC zugeordnet ist, die nicht mit den gleichen Bitleitungen verbunden sind, wie die gerade auszulesenden Speicherzellen MC. Beispielsweise wird gleichzeitig die Wortleitung WL0 und die Referenzwortleitung bREFWL aktiviert. Ferner ist zu diesem Zeitpunkt die Referenzleseleitung REFRD auf einem hohen Pegel und die Referenzschreibleitung REFWB auf einem niedrigen Pegel. Somit ist die jeweils auszulesende Speicherzelle MC mit dem einen Eingang des zugehörigen Leseverstärkers SAi und die entsprechende Referenzzelle RC mit dem anderen Eingang dieses Leseverstärkers verbunden. In Abhängigkeit des in der Speicherzelle MC gespeicherten Datums beziehungsweise der in der Referenzzelle gespeicherten Referenzinformation wird das Potential der mit diesen verbundenen Bitleitung BLi beziehungsweise bBLi unterschiedlich beeinflußt. Der Leseverstärker SAi verstärkt anschließend die sich daraufhin einstellende Potentialdifferenz an seinen Eingängen.

Da es sich bei den beschriebenen Speicherzellen MC und Referenzzelle RC um solche handelt, deren Speicherinhalt bei einem Lesezugriff zerstört wird, ist es notwendig, am Ende des Lesezugriffs die zuvor ausgelesene Information wieder in die Zellen zurückzuschreiben. Da es gewünscht ist, einerseits in die Referenzzellen RC immer die gleiche Referenzinformation einzuschreiben, andererseits (je nach zu speicherndem Datum) in die Speicherzellen MC jedoch mal eine logische "1" und mal eine logische "0" eingeschrieben werden muß, wird für das Rückschreiben bei diesem Ausführungsbeispiel die Referenzleseleitung REFRD auf ein niedriges Potential gebracht, so daß die ersten Schaltelemente S1 wieder sperren. Die Referenzzellen RC sind damit von den Leseverstärkern SAi abgekoppelt. Das Rückschreiben des aus der Speicherzelle MC ausgelesenen Datums erfolgt aber - wie bei FRAMs oder auch DRAMs üblich - durch den Leseverstärker SAi, indem einfach die von diesem verstärkte Information in der Speicherzelle MC gespeichert wird. Dagegen erfolgt das Rückschreiben der Referenzinformation in die Referenzzellen RC durch Leitendschalten der zweiten Schaltelemente S2 über die Referenzschreibleitung REFWB. Auf der ersten Potentialleitung P1 liegt ein entsprechendes Referenzpotential VRef an, das über das jeweilige zweite Schaltelement S2 in die immer noch über die Referenzwortleitung bREFWL ausgewählten Referenzzellen RC geschrieben wird. Nun ist der Lesezugriff abgeschlossen.

Ein Schreibzugriff erfolgt auf an sich bekannte Weise, indem die entsprechenden Speicherzellen MC über ihre Wortleitungen WLi selektiert werden und das gewünschte Datum vom Datenleitungspaar LDQi, bLDQi über den Leseverstärker SAi zum Bitleitungspaar BLi, bBLi übertragen wird. Dabei können die ersten Schaltelemente S1 gesperrt bleiben und es erfolgt keine Auswahl einer der Referenzwortleitungen REFWL, bREFWL.

Beim hier vorgestellten Ausführungsbeispiel sind die ersten S1 und zweiten S2 Schaltelemente sowie die Referenzzellen RC im selben Raster wie die Speicherzellen MC angeordnet. Hierdurch ergibt sich eine einfach herzustellende, kompakte Speicherarchitektur.

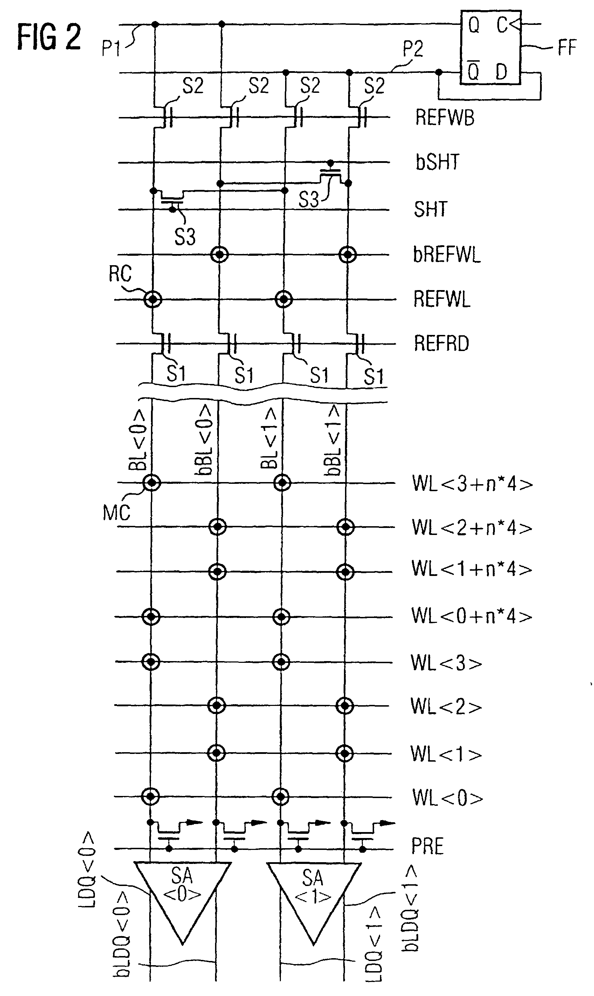

Figur 2 zeigt eine Abwandlung des in Figur 1 dargestellten Ausführungsbeispiels. Bei den im folgenden anhand der Figuren 2 bis 4 erläuterten Ausführungsbeispielen wird auf bereits in der Figur 1 erläuterte Komponenten und deren Funktion nur eingegangen, sofern Unterschiede bestehen. Der in Figur 2 dargestellte Speicher weist zusätzlich dritte Schaltelemente S3 in Form von n-Kanal-Transistoren auf. Das eine dritte Schaltelement S3 verbindet die Bitleitungen BL0 und BL1 miteinander und das andere Schaltelement S3 die Bitleitungen bBL0 und bBL1. Die Gates der dritten Schaltelemente S3 sind mit je einer Steuerleitung SHT, bSHT verbunden. Die dritten Schaltelemente S3 sind im zweiten Bereich der Bitleitungen BLi, bBLi angeordnet, der sich zwischen den ersten S1 und zweiten S2 Schaltelementen befindet. Ein weiterer Unterschied gegenüber dem Ausführungsbeispiel in Figur 1 besteht darin, daß über die zweiten Schaltelemente S2 nur das erste Bitleitungspaar BL0, bBL0 mit der ersten Potentialleitung BL1 verbunden ist, während das zweite Bitleitungspaar BL1, bBL1 über seine zweiten Schaltelemente mit einer zweiten Potentialleitung P2 verbunden ist.

Die beiden Potentialleitungen P1, P2 sind mit je einem Ausgang eines Wechsel-Flip-Flops FF verbunden, so daß sie gegensätzliche Potentiale aufweisen. Die dritten Schaltelemente S3 und die beiden Potentialleitungen P1, P2 dienen der Erzeugung des bei einem Lesezugriff auf eine der Speicherzellen MC notwendigen Referenzpotentials. Beim Einschreiben der Referenzinformation über die zweiten Schaltelemente S2 in die Referenzzellen RC wird in die Referenzzellen RC des ersten Bitleitungspaares BL0, bBL0 eine Referenzinformation geschrieben, die invers zu derjenigen ist, die in die Referenzzellen RC des zweiten Bitleitungspaares BL1, bBL1 geschrieben wird. Das Flip-Flop FF dient zur Erzeugung dieser beiden inversen Referenzinformationen auf den Potentialleitungen P1, P2. Über einen Takteingang C des Flip-Flops FF wird ein Wechsel in der Polarität seiner Ausgangssignale in regelmäßigen zeitlichen Abständen bewirkt. Hierdurch wird verhindert, daß in die Referenzzellen RC immer derselbe logische Zustand eingeschrieben wird, was zu einer Ermüdung der entsprechenden Referenzzelle RC beziehungsweise des ferroelektrischen Dielektrikum ihres Speicherkondensators C führen würde. Mit dem Flip-Flop FF ist es möglich, jeweils unterschiedliche logische Zustände in die Referenzzellen RC der beiden Bitleitungspaare zu schreiben, die mit der Taktung des Flip-Flops FF in größeren zeitlichen Abständen alternieren. Die inversen Referenzinformationen können bei anderen Ausführungsbeispielen statt mit einem Flipflop auch auf andere Weise zugeführt werden. Insbesondere können sie statisch zugeführt werden, ohne daß sich ihre Polarität ändert.

Wird beim Speicher gemäß Figur 2 bei einem Lesezugriff beispielsweise wieder die Wortleitung WL0 und die Referenzwortleitung bREFWL aktiviert, erzeugen die beiden aktivierten Referenzzellen RC aufgrund ihres gegensätzlichen logischen Pegels ein jeweils unterschiedliches Potential auf den entsprechenden Bitleitungen bBLi, mit denen sie über die ersten Schaltelemente S1 leitend verbunden sind. Anschließend erfolgt über die diesen beiden Bitleitungen zugeordnete Steuerleitung bSHT ein Leitendschalten des entsprechenden dritten Schaltelementes S3. Das den beiden anderen Bitleitungen BLi zugeordnete dritte Schaltelement S3 bleibt dagegen gesperrt. Das leitende dritte Schaltelement S3 schließt die beiden mit ihm verbundenen Bitleitungen bBLi kurz. Hierdurch erfolgt ein Potentialausgleich zwischen diesen beiden Bitleitungen, wodurch das gewünschte Referenzpotential erzeugt wird. Nun werden die beiden Leseverstärker SAi aktiviert, die jeweils die Potentialdifferenz zwischen dem Referenzpotential und dem sich auf der mit der jeweiligen aktivierten Speicherzelle MC elektrisch verbundenen Bitleitung BLi einstellenden Potential verstärken.

Das Rückschreiben am Ende des Lesezugriffs erfolgt beim Speicher gemäß Figur 2 ähnlich wie bei demjenigen aus Figur 1. Zuvor wird jedoch das dritte Schaltelement S3 über die Steuerleitung bSHT wieder gesperrt. Während des Rückschreibens der Referenzinformation in die Referenzzellen RC sind wiederum die ersten Schaltelemente S1 gesperrt und die zweiten Schaltelemente S2 leitend.

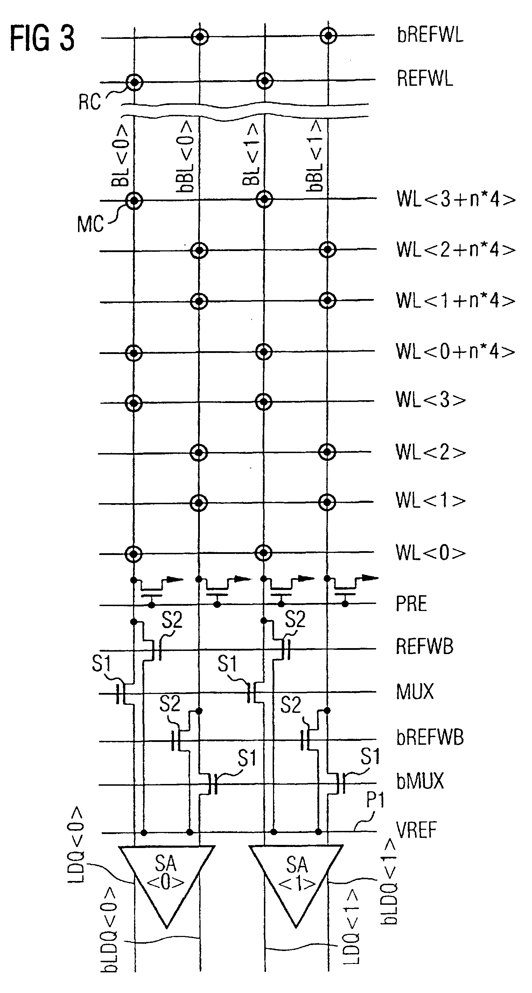

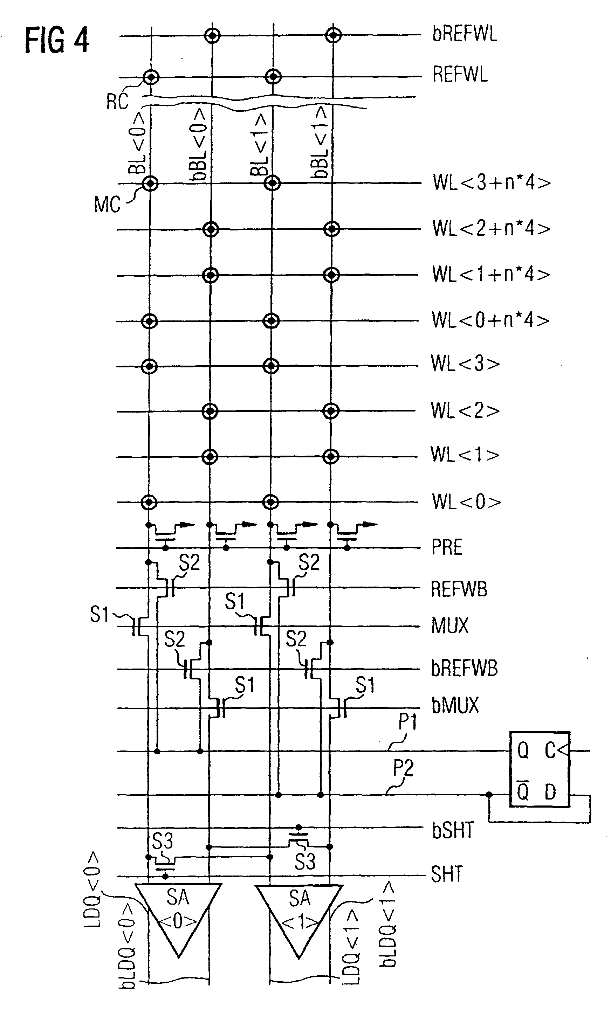

Die Figuren 3 und 4 zeigen Ausführungsbeispiele des integrierten Speichers, bei dem die ersten Schaltelemente S1, die zweiten Schaltelemente S2 und die Potentialleitungen P1, P2 am den Leseverstärkern SAi zugewandten Ende der Bitleitungen BLi, bBLi angeordnet sind. Sowohl in Figur 3 als auch in Figur 4 sind die Bitleitungen BLi, bBLi also über die ersten Schaltelemente S1 mit den Leseverstärkern SAi verbunden. Auf diese Weise wird ein zusammenhängendes Speicherzellenfeld der Speicherzellen MC mit den Referenzzellen RC ermöglicht, da die ersten Schaltelemente S1 nun die Bitleitungen nicht mehr in Bereiche unterteilen, die entweder mit den Speicherzellen, oder mit den Referenzzellen verbunden sind. Da in der Regel in der Nähe der Leseverstärker SAi ausreichend Platz zur Verfügung steht, ist die Realisierung gemäß Figur 3 und 4 unter Umständen problemloser möglich als gemäß Figur 1 und 2, auch wenn der Speicher mit sehr kleinen Strukturgrößen erzeugt wird. Ausreichend Platz in der Nähe der Leseverstärker SAi steht insbesondere dann zur Verfügung, wenn diese über entsprechende Multiplexer (nicht dargestellt) jeweils mit mehreren Bitleitungspaaren verbunden sind.

Der Speicher gemäß Figur 3 unterscheidet sich von demjenigen in Figur 1 und der Speicher in Figur 4 unterscheidet sich von demjenigen in Figur 2 weiterhin darin, daß die mit den Bitleitungen BL0 und BL1 verbundenen ersten Schaltelemente S1 mit einer ersten Auswahlleitung MUX und die beiden anderen ersten Schaltelemente S1 mit einer zweiten Auswahlleitung bMUX verbunden sind. Ein weiterer Unterschied besteht darin, daß die mit den Bitleitungen BL0 und BL1 verbundenen zweiten Schaltelemente S2 an ihren Gates mit einer ersten Referenzschreibleitung REFWB und die mit den Bitleitungen bBL0 und bBL1 verbundenen zweiten Schaltelemente S2 an ihren Gates mit einer zweiten Referenzschreibleitung bREFWB verbunden sind.

Ein Lesezugriff auf den Speicher in Figur 3 erfolgt beispielsweise wieder durch Aktivierung der Wortleitung WL0 und der Referenzwortleitung bREFWL. Außerdem wird die erste Auswahlleitung MUX und die zweite Auswahlleitung bMUX auf einen hohen Pegel gebracht, während die beiden Referenzschreibleitungen REFWB, bREFWB ein niedriges Potential haben. Es sind dann alle ersten Schaltelemente S1 leitend und alle zweiten Schaltelemente S2 gesperrt. Nach dem Verstärken des sich einstellenden Differenzsignals durch die Leseverstärker SAi erfolgt ein Rückschreiben in die Speicherzellen MC und die Referenzzellen RC dadurch, daß die Referenzzellen RC von den Leseverstärkern abgekoppelt werden, indem die entsprechenden ersten Schaltelemente S1 sperren. Dies erfolgt, indem die zweite Auswahlleitung bMUX einen niedrigen Pegel annimmt, während die erste Auswahlleitung MUX einen hohen Pegel behält. Anschließend nimmt die zweite Referenzschreibleitung bREFWB einen hohen Pegel an, so daß die mit diesem verbundenen zweiten Schaltelemente S2 leiten. Die erste Referenzschreibleitung REFWB bleibt dabei auf niedrigem Pegel. Nun erfolgt, da die Wortleitung WL0 und die Referenzwortleitung bREFWL weiterhin aktiviert sind, über die mit den Bitleitungen BLi verbundenen ersten Schaltelemente S1 ein Rückschreiben der vom Leseverstärker SAi verstärkten Information in die Speicherzellen MC und gleichzeitig ein Übertragen der gewünschten Referenzinformation von der ersten Potentialleitung P1 über die mit den Bitleitungen bBLi verbundenen zweiten Schaltelemente S2 in die beiden ausgewählten Referenzzellen RC.

Der in Figur 4 dargestellte Speicher generiert das am Leseverstärker SAi benötigte Referenzpotential wiederum auf die bezüglich Figur 2 bereits beschriebene Art durch Auslesen zweier Referenzzellen RC, in denen zueinander inverse Informationen gespeichert sind und anschließendes Kurzschließen über das entsprechende dritte Schaltelement S3. Da die dritten Schaltelemente S3 in Figur 4 direkt an den Leseverstärkern SAi angeordnet sind, ist es für das Kurzschließen der aus den Referenzzellen RC ausgelesenen Referenzinformationen notwendig, daß zuvor die ersten Schaltelemente S1 leitend geschaltet worden sind. Die dritten Schaltelemente S3 können jedoch auch auf der von den Leseverstärkern SAi abgewandten Seite der ersten Schaltelemente S1 angeordnet sein, so daß die ersten Schaltelemente S1 erst leitend geschaltet werden müssen, wenn der Kurzschluß über das entsprechende dritte Schaltelement S3 bereits erfolgt ist. Die Ansteuerung der ersten und zweiten Schaltelemente S1, S2 in Figur 4 erfolgt äquivalent wie in Figur 3.

Bei den Ausführungsbeispielen gemäß Figur 2 und Figur 4 ist es wichtig, daß nach dem Kurzschließen der beiden die Referenzinformationen führenden Bitleitungen durch das entsprechende dritte Schaltelement S3 letzteres wieder gesperrt wird, bevor die Leseverstärker SAi aktiviert werden und die festgestellte Potentialdifferenz verstärken. Andernfalls kommt es beim Auslesen zueinander inverser Informationen aus den beiden zeitgleich auszulesenden Speicherzellen MC zu einem Kurzschluß zwischen den beiden dann inverse Pegel treibenden Leseverstärkern SAi.

Bei den hier geschilderten Ausführungsbeispielen erfolgt jeweils das Rückschreiben der aus den Speicherzellen MC ausgelesenen Daten über die Leseverstärker SAi und das Rückschreiben der aus den Referenzzellen RC ausgelesenen Referenzinformation über die entsprechenden Potentialleitungen P1, P2 jeweils gleichzeitig. Außerdem erfolgt bei allen Ausführungsbeispielen das Auslesen der Daten aus den Speicherzellen MC und der Referenzinformation aus den Referenzzellen RC sowie das Kurzschließen der mit den Referenzzellen RC verbundenen Bitleitung über die dritten Schaltelemente S3 jeweils gleichzeitig.

Die Ausführungsbeispiele gemäß Figur 1 und Figur 2 haben den weiteren Vorteil, daß beim Rückschreiben der Referenzinformation in die Referenzzellen RC nicht die gesamte Kapazität der Bitleitungen BLi, bBLi mit der jeweiligen Potentialleitung P1, P2 verbunden wird, sondern nur der sehr kurze Bereich der Bitleitungen, der mit den Referenzzellen RC verbunden ist. Hierdurch kann das Rückschreiben der Referenzinformation über die zweiten Schaltelemente S2 mit geringen Verlusten und in sehr kurzer Zeit erfolgen.

## Patentansprüche

1. Integrierter Speicher
- mit Speicherzellen(MC),
-- die jeweils in Kreuzungspunkten von Wortleitungen (WLi) mit je einer Bitleitung (BL0, bBL0) eines ersten Bitleitungspaares angeordnet sind
-- und die jeweils ein Auswahlschaltelement (T) aufweisen, über das sie mit der jeweiligen Bitleitung verbunden sind und dessen Steueranschluß mit der jeweiligen Wortleitung verbunden ist,
- mit einem differentiellen Leseverstärker (SA0), der mit dem ersten Bitleitungspaar verbunden ist,
- mit zwei Referenzzellen (RC),
-- die jeweils in einem Kreuzungspunkt einer der Bitleitungen (BL0, bBL0) mit jeweils einer Referenzwortleitung (REFWL, bREFWL) angeordnet sind,
-- die den gleichen Aufbau wie die Speicherzellen (MC) haben
-- und die ein Auswahlschaltelement (T) aufweisen, über das sie an einem Schaltungsknoten (A) mit der jeweiligen Bitleitung verbunden sind und dessen Steueranschluß mit der jeweiligen Referenzwortleitung (REFWL, bREFWL) verbunden ist,
- mit ersten Schaltelementen (S1), über die die Schaltungsknoten (A) mit dem Leseverstärker (SA0) verbunden sind,
- und mit zweiten Schaltelementen (S2), über die die Schaltungsknoten (A) mit einer ersten Potentialleitung (P1) verbunden sind, die zur Zuführung eines in den Referenzzellen (RC) zu speichernden ersten Potentials dient,
- mit einem zweiten Bitleitungspaar (BL1, bBL1), das mit einem weiteren differentiellen Leseverstärker (SA1) verbunden ist und das wie das erste Bitleitungspaar (BL0, bBL0) entsprechende Speicherzellen (MC) und Referenzzellen (RL) sowie erste (S1) und zweite (S2) Schaltelemente aufweist,
- mit zwei dritten Schaltelementen (S3), die jeweils eine der Bitleitungen (BL0, bBL0) des ersten Paares mit einer der Bitleitungen (BL1, bBL1) des zweiten Paares verbinden,
und mit einer zweiten Potentialleitung (P2), mit der die Schaltungsknoten (A) der Bitleitungen (BL1, bBL1) des zweiten Paares über die entsprechenden zweiten Schaltelemente (S2) verbunden sind und die zur Zuführung eines in den Referenzzellen (RC) des zweiten Bitleitungspaares zu speichernden zweiten Potentials dient.

2. Integrierter Speicher nach Anspruch 1,
- dessen Referenzzellen (RC) an einem dem Leseverstärker (SA0) gegenüberliegenden Ende der jeweiligen Bitleitung (BL0, bBL0) angeordnet sind
- und dessen erste Schaltelemente (S1) zwischen den Schaltungsknoten (A) und einem Bereich der jeweiligen Bitleitung, der mit den Auswahlschaltelementen (T) der zugehörigen Speicherzellen (MC) verbunden ist, angeordnet sind.

3. Integrierter Speicher nach Anspruch 2,
dessen zweite Schaltelemente (S2) und dessen erste Potentialleitung (P1) ebenfalls am vom Leseverstärker (SA0) abgewandten Ende der jeweiligen Bitleitung (BL0, bBL0) angeordnet sind.

4. Integrierter Speicher nach Anspruch 1,
dessen erste Schaltelemente (S1) das dem Leseverstärker (SA0) zugewandte Ende der jeweiligen Bitleitung (BL0, bBL0) mit dem Leseverstärker verbinden.

5. Integrierter Speicher nach Anspruch 4,
dessen zweite Schaltelemente (S2) und dessen erste Potentialleitung (P1) am dem Leseverstärker (SA0) zugewandten Ende der jeweiligen Bitleitung (BL0, bBL0) angeordnet sind.

6. Integrierter Speicher nach Anspruch 4,
- bei dem während eines Lesezugriffs auf eine der Speicherzellen (MC) einer der Bitleitungen (BL0)
-- das Auswahlschaltelement (T) dieser Speicherzelle (MC) und das Auswahlschaltelement der Referenzzelle (RC) der anderen Bitleitung (bBL0) leitend sind
-- sowie beide ersten Schaltelemente (S1) leitend und beide zweiten Schaltelemente (S2) nicht leitend sind,
- und bei dem während eines während des Lesezugriffs erfolgenden Rückschreibens der zuvor aus der entsprechenden Speicherzelle (MC) ausgelesenen Information durch den Leseverstärker (SA0)
-- die Auswahlschaltelemente (T) der betreffenden Speicherzelle (MC) und der Referenzzelle (RC) leitend sind
-- und nur das mit der einen Bitleitung (BL0) verbundene erste Schaltelement (S1) und das mit der anderen Bitleitung (bBL0) verbundene zweite Schaltelement (S2) leitend sind.

7. Integrierter Speicher nach Anspruch 1,
mit einer Steuereinheit (FF), die mit den beiden Potentialleitungen (P1, P2) verbunden ist, zur Erzeugung der beiden Potentiale mit jeweils alternierenden Pegeln.

8. Betriebsverfahren für einen integrierten Speicher mit Bitleitungspaaren, wobei jeder Bitleitung eines Bitleitungspaares eine Speicherzelle und eine Referenzzelle zugeordnet ist, mit folgenden Schritten:
- Auslesen einer Information aus zwei Speicherzellen (MC) und Übertragen der Informationen über zwei erste Bitleitungen (BL0, BL1) zu ersten Eingängen von zwei differentiellen Leseverstärkern (SA0, SA1),
- Auslesen von Referenzinformationen aus zwei Referenzzellen (RC) und Übertragen der Referenzinformationen über zwei zweite Bitleitungen (bBL0, bBL1) zu zweiten Eingängen der Leseverstärker (SA0, SA1),
- Verstärken der an den Eingängen der Leseverstärker (SA0, SA1) anliegenden Spannungen durch die Leseverstärker,
- Abkoppeln der zwei Referenzzellen (RC) von den Leseverstärkern,
- Verbinden der Referenzzellen (RC) mit Potentialleitungen (P1, P2),
- und Übertragen der Potentiale von den Potentialleitungen (P1, P2) über die zweiten Bitleitungen (bBL0, bBL1) zu den Referenzzellen (RC),
wobei die Potentiale der Potentialleitungen (P1, P2) unterschiedlich sind,
Verbinden der zwei zweiten Bitleitungen (bBL0, bBL1) zum Einstellen eines Referenzpotentials.

9. Betriebsverfahren nach Anspruch 8 mit folgendem weiteren Schritt:
Rückschreiben der durch die Leseverstärker (SA0, SA1) verstärkten Signale über die ersten Bitleitungen (BL0, BL1) in die Speicherzellen (MC), gleichzeitig zum Übertragen der Potentiale über die zweiten Bitleitungen (bBL0, bBL1) in die Referenzzellen (RC).

## Claims

1. Integrated memory
- having memory cells (MC),
-- which in each case are arranged at crossing points of word lines (WLi) each having a bit line (BL0, bBL0) of a first pair of bit lines
-- and which in each case have a select switching element (T), via which they are connected to the respective bit line and whose control connection is connected to the respective word line,
- having a differential read amplifier (SA0), which is connected to the first pair of bit lines,
- having two reference cells (RC),
-- which in each case are arranged at a crossing point of one of the bit lines (BL0, bBL0) with in each case a reference word line (REFWL, bREFWL),
-- which have the same structure as the memory cells (MC)
-- and which have a select switching element (T), via which they are connected to the respective bit line at a circuit node (A) and whose control connection is connected to the respective reference word line (REFWL, bREFWL),
- having first switching elements (S1), via which the circuit nodes (A) are connected to the read amplifier (SA0),
- and having second switching elements (S2), via which the circuit nodes (A) are connected to a first potential line (P1), which is used to supply a first potential to be stored in the reference cells (RC),
- having a second pair of bit lines (BL1, bBL1), which is connected to a further differential read amplifier (SA1) and which, like the first pair of bit lines (BL0, bBL0), has corresponding memory cells (MC) and reference cells (RC) and also first (S1) and second (S2) switching elements,
- having two third switching elements (S3), which in each case connect one of the bit lines (BL0, bBL0) of the first pair to one of the bit lines (BL1, bBL1) of the second pair,
and having a second potential line (P2), to which the circuit nodes (A) of the bit lines (BL1, bBL1) of the second pair are connected via the corresponding second switching elements (S2), and which serves to supply a second potential to be stored in the reference cells (RC) of the second pair of bit lines.

2. Integrated memory according to Claim 1,
- whose reference cells (RC) are arranged at one end of the respective bit line (BL0, bBL0) opposite the read amplifier (SA0),
- and whose first switching elements (S1) are arranged between the circuit nodes (A) and an area of the respective bit line which is connected to the select circuit elements (T) of the associated memory cells (MC).

3. Integrated circuit according to Claim 2, whose second switching elements (S2) and whose first potential line (P1) are likewise arranged at the end of the respective bit line (BL0, bBL0) facing away from the read amplifier (SA0).

4. Integrated memory according to Claim 1, whose first switching elements (S1) connect the end of the respective bit line (BL0, BbL0) facing the read amplifier (SA0) to the read amplifier.

5. Integrated circuit according to Claim 4, whose second switching elements (S2) and whose first potential line (P1) are arranged at the end of the respective bit line (BL0, bBL0) facing the read amplifier (SA0).

6. Integrated memory according to Claim 4,
in which, during a read access to one of the memory cells (MC) of one of the bit lines (BL0)
-- the select switching element (T) of this memory cell (MC) and the select switching element of the reference cell (RC) of the other bit line (bBL0) are turned on
-- and also both first switching elements (S1) are turned on and both second switching elements (S2) are turned off,
- and in which, during the rewriting, carried out during the read access, of the information previously read out from the corresponding memory cell (MC) by means of the read amplifier (SA0)
-- the select switching elements (T) of the relevant memory cell (MC) and of the reference cell (RC) are turned on
-- and only the first switching element (S1) connected to the one bit line (BL0) and the second switching element (S2) connected to the other bit line (bBLO) are turned on.

7. Integrated memory according to Claim 1, having a control unit (FF), which is connected to the two potential lines (P1, P2), to generate the two potentials with respectively alternating levels.

8. Operating method for an integrated memory having pairs of bit lines, each bit line of a pair of bit lines being assigned a memory cell and a reference cell, having the following steps:
- reading information out from two memory cells (MC) and transferring the information via two first bit lines (BL0, BL1) to first inputs of two differential read amplifiers (SA0, SA1),
- reading reference information out from two reference cells (RC) and transferring the reference information via two second bit lines (bBL0, bBL1) to second inputs of the read amplifiers (SA0, SA1),
- amplifying the voltages present at the inputs of the read amplifiers (SA0, SA1) by means of the read amplifiers,
- uncoupling the reference cells (RC) from the read amplifiers,
- connecting the reference cells (RC) to potential lines (P1, P2),
- and transferring the potentials from the potential lines (P1, P2) via the second bit lines (bBL0, bBL1) to the reference cells (RC), the potentials of the potential lines (P1, P2) being different,
connecting the two second bit lines (bBL0, bBL1) in order to set a reference potential.

9. Operating method according to Claim 8 having the following further step:
rewriting the signals amplified by the read amplifiers (SA0, SA1) into the memory cells (MC) via the first bit lines (BL0, BL1), at the same time as the potentials are transferred into the reference cells (RC) via the second bit lines (bBL0, bBL1).

## Revendications

1. Mémoire intégrée
- comprenant des cellules (MC) de mémoire,
- qui sont disposées respectivement aux points d'intersection de lignes (WLi) de mots avec respectivement une ligne (BL0, bBL0) de bits d'une première paire de lignes de bits
- et qui ont respectivement un élément (T) de commutation de sélection, par lequel elles sont reliées à la ligne de bits respective et dont la borne de commande est reliée à la ligne de mots respective,
- comprenant un amplificateur (SA0) différentiel de lecture qui est relié à la première paire de lignes de bits,
- comprenant deux cellules (RC) de référence,
- qui sont placées respectivement en un point d'intersection de l'une des lignes (BL0, bBL0) de bits avec respectivement une ligne (REFWL, bREFWL) de mots de référence,
- qui ont la même structure que les cellules (MC) de mémoire
- et qui ont un élément (T) de commutation de sélection, par lequel elles sont reliées en un noeud (A) de circuit à la ligne de bits respective et dont la borne de commande est reliée à la ligne (REFWL, bREFWL) de mots de référence respective,
- comprenant de premiers éléments (S1) de commutation, par lesquels les noeuds (A) de circuit sont reliés à l'amplificateur (SA0) de lecture,
- et comprenant des deuxièmes éléments (S2) de commutation, par lesquels les noeuds (A) du circuit sont reliés à une première ligne (P1) de potentiel qui sert à l'envoi d'un premier potentiel à mémoriser dans les cellules (RC) de référence,
- comprenant une deuxième paire (BL1, bBL1) de lignes de bits qui est reliée à un autre amplificateur (SA1) différentiel de lecture et qui a, comme la première paire (BL0, bBL0) de lignes de bits, des cellules (MC) de mémoire et des cellules (RL) de référence correspondantes, ainsi que des premiers (S1) et des deuxièmes (S2) éléments de commutation,
- comprenant deux troisièmes éléments (S3) de commutation qui relient respectivement l'une des lignes (BL0, bBL0) de bits de la première paire à l'une des lignes (BL1, bBL1) de bits de la deuxième paire,
et comprenant une deuxième ligne (P2) de potentiel par laquelle les noeuds (A) du circuit des lignes (BL1, bBL1) de bits de la deuxième paire sont reliés par les deuxièmes éléments (S2) de circuit correspondants et qui sert à l'envoi d'un deuxième potentiel à mémoriser dans les cellules (RC) de référence de la deuxième paire de lignes de bits.

2. Mémoire intégrée suivant la revendication 1,
- dont des cellules (RC) de référence sont placées à une extrémité, opposée à l'amplificateur (SA0) de lecture, de la ligne (BL0, bBL0) de bits respective
- et dont des premiers éléments (S1) de commutation sont placés entre les noeuds (A) du circuit et une région de la ligne respective de bits, qui est reliée aux éléments (T) de commutation de sélection des cellules (MC) de mémoire associées.

3. Mémoire intégrée suivant la revendication 2,
dont deux éléments (S2) de commutation et dont la première ligne (P1) de potentiel sont placés également à l'extrémité de la ligne (BL0, bBL0) de bits respective, qui est éloignée de l'amplificateur (SA0) de lecture.

4. Mémoire intégrée suivant la revendication 1,
dont des premiers éléments (S1) de commutation relient à l'amplificateur de lecture l'extrémité de la ligne (BL0, bBL0) de bits respective, qui est tournée vers l'amplificateur (SA0) de lecture.

5. Mémoire intégrée suivant la revendication 4,
dont des deuxièmes éléments (S2) de commutation et dont la première ligne (P1) de potentiel sont placés à l'extrémité de la ligne (BL0, bBL0) de bits respective, qui est tournée vers l'amplificateur (SA0) de lecture.

6. Mémoire intégrée suivant la revendication 4,
- dans laquelle, pendant un accès en lecture sur l'une des cellules (MC) de mémoire de l'une des lignes (BL0) de bits
- l'élément (T) de commutation de sélection de cette cellule (MC) de mémoire et l'élément de commutation de sélection de la cellule (RC) de référence de l'autre ligne (bBL0) de bits sont conducteurs
- et les deux premiers éléments (S1) de circuit sont conducteurs et les deux deuxièmes éléments (S2) de circuit ne sont pas conducteurs,
- et dans laquelle, pendant une réécriture de l'information lue auparavant dans la cellule (MC) de mémoire correspondante par l'amplificateur (SA0) de lecture,
- des éléments (T) de commutation de sélection de la cellule (MC) de mémoire et de la cellule (RC) de référence concernées sont conducteurs
- et seul le premier élément (S1) de commutation relié à la une ligne (BL0) de bits et le deuxième élément (S2) de commutation relié à l'autre ligne (bBL0) de bits sont conducteurs.

7. Mémoire intégrée suivant la revendication 1,
ayant une unité (FF) de commande qui est reliée aux deux lignes (P1, P2) de potentiel pour la production des deux potentiels de niveau respectivement alterné.

8. Procédé pour faire fonctionner une mémoire intégrée comprenant des paires de lignes de bits, une cellule de mémoire et une cellule de référence étant associées à chaque ligne de bits et une paire de lignes de bits comprenant les stades suivants :
- on lit une information dans deux cellules (MC) de mémoire et on transmet l'information par deux premières lignes (BL0, BL1) de bits à de premières entrées de deux amplificateurs (SA0, SA1) différentiels de lecture,
- on lit des informations de référence dans deux cellules (RC) de référence et on transmet les informations de référence par deux deuxièmes lignes (bBL0, bBL1) de bits à des deuxièmes entrées de l'amplificateur (SA0, SA1) de lecture,
- on amplifie par l'amplificateur de lecture les tensions appliquées aux entrées de l'amplificateur (SA0, SA1) de lecture,
- on découple les deux cellules (RC) de référence des amplificateurs de lecture,
- on relie les cellules (RC) de référence à des lignes (P1, P2) de potentiel,
- et on transmet les potentiels des lignes (P1, P2) de potentiel aux cellules (RC) de référence par les deuxièmes lignes (bBL0, bBL1) de bits,
dans lequel les potentiels des lignes (P1, P2) de potentiel sont différents,
on relie les deux deuxièmes lignes (bBL0, bBL1) de bits pour établir un potentiel de référence.

9. Procédé pour faire fonctionner une mémoire intégrée suivant la revendication 8, comprenant le stade supplémentaire suivant :
on réécrit les signaux amplifiés par l'amplificateur (SA0, SA1) de lecture par les premières lignes (BL0, BL1) de bits dans les cellules (MC) de mémoire, tout en transmettant les potentiels aux cellules (RC) de référence par les deuxièmes lignes (bBL0, bBL1) de bits.
